# NEUE EUROPÄISCHE PATENTSCHRIFT

(11) **EP 1 670 844 B2**
(45) Veröffentlichungstag und Bekanntmachung des Hinweises auf die Entscheidung über den Einspruch: **01.03.2017**
(45) Hinweis auf die Patenterteilung: 27.04.2011
(21) Anmeldenummer: 04765334.0
(22) Anmeldetag: 17.09.2004
(51) Int. Cl.: C08G 61/02, C08G 61/10, C08G 61/12, H01L 51/00, H01L 51/50

(54) **WEISS EMITTIERENDE COPOLYMERE, DEREN DARSTELLUNG UND VERWENDUNG**
WHITE-EMITTING COPOLYMERS, REPRESENTATION AND USE THEREOF
COPOLYMERES A EMISSION BLANCHE, REPRESENTATION ET UTILISATION DE CEUX-CI

(30) Priorität: 20.09.2003 DE 10343606
(43) Veröffentlichungstag der Anmeldung: 21.06.2006
(73) Patentinhaber: Merck Patent GmbH, 64293 Darmstadt (DE)
(72) Erfinder: LUDERMANN, Aurelie, 60322 Frankfurt (DE); BÜSING, Arne, 65929 Frankfurt (DE); HEUN, Susanne, 65812 Bad Soden (DE); STEIGER, Jürgen, 40237 Düsseldorf (DE); GERHARD, Anja, 97209 Veitshöchheim (DE); SCHULTE, Niels, 65779 Kelkheim (DE); BECKER, Heinrich, 65719 Hofheim (DE)
(86) Internationale Anmeldenummer: PCT/EP2004/010439
(87) Internationale Veröffentlichungsnummer: WO 2005/030827

(56) Entgegenhaltungen:
- EP-A1- 1 424 350
- WO-A-02/068435
- WO-A-02/077060
- WO-A-03/020790
- WO-A1-00/46321
- WO-A1-2004/060970
- WO-A2-01/49768
- US- - 10/ 324 270
- CHEN X. ET AL: 'High-Efficiency Red-Light Emission from Polyfluorenes Grafted with Cyclometalated Iridium Complexes and Charge Transport Moiety' J. AM. CHEM. SOC. Bd. 125, 2003, Seiten 636 - 637
- JEONG E. ET AL: 'Synthesis and Characterization of Indenol ¬1,2-b|fluorene-Based White Light-Emitting Copolymer' JOURNAL OF POLYMER SCIENCE PART A: POLYMER CHEMISTRY Bd. 47, 2009, Seiten 3467 - 3479
- NIU Y.-H. ET AL: 'High-efficiency polymer light-emitting diodes with stable saturated red emissionbased on blends of dioctylfluorene-benzothiadiazole-dithienylb enzothiadiazole terpolymers and poly¬2-methoxy,5-(2-ethylhexoxy)-1,4-phenyl ene vinylene|' APPLIED PHYSICS LETTERS Bd. 82, 31 März 2003 - 2003, Seiten 2163 - 2165
- HOU Q. ET AL: 'Synthesis and electroluminescent properties of fluorene-based copolymers' SYNTHETIC METALS Bd. 2003, 2003, Seiten 135 - 136
- HUANG J. ET AL: 'Novel Red Electroluminescent Polymers Derived from Carbazole and 4,7-Bis(2-thienyl)-2,1,3-benzothiadiazole' MACROMOLECULAR RAPID COMMUNICATIONS Bd. 23, Nr. 12, 2002, Seiten 709 - 712

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423283 offenbart sind. Seit kurzem ist auch ein erstes, wenn auch einfaches Produkt (eine kleine Anzeige in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln. Vor allem ist es erforderlich, entweder Polymere für alle Emissionsfarben (Rot, Grün, Blau) zur Verfügung zu stellen, die den Anforderungen des Marktes (Farbsättigung, Effizienz, operative Lebensdauer, um die wichtigsten zu nennen) gerecht werden, oder weiß emittierende Polymere zur Verfügung zu stellen, die diesen Anforderungen genügen und die mit Farbfiltern in vollfarbigen Vorrichtungen verwendet werden können.

Als Polymere wurden verschiedene Materialklassen entwickelt. So kommen hierfür Poly-para-phenylenvinylene (PPV) in Betracht. Des Weiteren sind auch Polyfluoren- und Polyspirobifluoren-Derivate eine Möglichkeit, ebenso wie Polymere, die eine Kombination dieser beiden Strukturelemente enthalten. Im Allgemeinen sind für derartigen Einsatz Polymere, welche Poly-para-phenylen (PPP) als Strukturelement enthalten, möglich. Neben den oben bereits genannten Klassen kommen hier beispielsweise auch die so genannten Leiter-PPPs ("Ladder-PPPs" = LPPP), Polytetrahydropyrene, Polyindenofluorene oder Polydihydrophenanthrene in Frage.

Für die Erzeugung aller drei Emissionsfarben ist es notwendig, bestimmte Comonomere in die entsprechenden Polymere einzupolymerisieren (vgl. z. B. WO 00/46321, WO 03/020790 und WO 02/077060). So ist in der Regel, ausgehend von einem blau emittierenden Grundpolymer ("Backbone"), die Erzeugung der beiden anderen Primärfarben Rot und Grün möglich.

Derzeit wird die Kommerzialisierung sowohl von einfarbigen als auch mehr- bzw. vollfarbigen Displays basierend auf PLEDs erwogen. Einfarbige elektrolumineszierende Vorrichtungen können vergleichsweise einfach erzeugt werden, indem die Materialien durch Flächenbeschichtung aus Lösung (z. B. durch Spin-Coating, etc.) verarbeitet werden. Üblicherweise wird hier die Strukturierung, d. h. die Ansteuerung der einzelnen Bildpunkte, bei den "Zuleitungen", d. h. beispielsweise bei den Elektroden, durchgeführt. Bei mehr- bzw. vollfarbigen Anzeigeelementen ist der Einsatz von Druckverfahren (z. B. Tintenstrahldruck, Off-Set-Druck, Siebdruck, etc.) sehr wahrscheinlich. Dass dies erhebliche Probleme bereitet, ist alleine schon aus den Dimensionen verständlich: Es müssen Strukturen im Bereich von einigen 10 µm bei Schichtdicken im Bereich von weniger als 100 nm bis zu wenigen µm geschaffen werden.

Eine weitere Möglichkeit zur Herstellung vollfarbiger Displays unter Vereinfachung oder Umgehung aufwändiger Drucktechniken besteht darin, ein weiß emittierendes Polymer großflächig oder strukturiert aufzutragen und die einzelnen Farben daraus durch einen Farbfilter zu erzeugen, wie es bereits bei Flüssigkristallanzeigen (LCD) Stand der Technik ist.
Weiß emittierende Polymere können weiterhin Verwendung finden für monochrom weiße Displays. Des Weiteren ist die Verwendung weiß emittierender Polymere in Flüssigkristallanzeigen als Backlight möglich, sowohl für monochrome wie auch für mehrfarbige Displays. In der breitest möglichen Anwendung ist weiße Emission allgemein für Beleuchtungszwecke (Illumination) einzusetzen, da Weiß dem Sonnenlicht am ähnlichsten ist.

Wie man also sieht, besteht ein großer Bedarf an weiß emittierenden Polymeren. Es ist jedoch schwierig oder unmöglich, ein einzelnes Chromophor zu finden, das Licht im gesamten sichtbaren Bereich emittiert. Ohne in der Erfindung an eine bestimmte Theorie gebunden sein zu wollen, lässt sich Weiß nicht einer bestimmten Wellenlänge bzw. einem bestimmten Wellenlängenbereich zuordnen, wie es für Rot, Grün und Blau zutrifft. Erst die additive Farbmischung beispielsweise von emittiertem Licht der Primärfarben Rot, Grün und Blau oder einer Mischung von Komplementärfarben, beispielsweise Blau und Gelb, lässt das emittierte Licht in Summe weiß erscheinen.

Die meisten bekannten weiß emittierenden Polymer-Systeme sind daher Blends (Mischungen) aus einem blau emittierenden Polymer und einem geringen Anteil einer gelb bis rot emittierenden polymeren oder niedermolekularen Verbindung (z. B. US 6127693). Auch ternäre Blends, in denen dem blau emittierenden Polymer grün und rot emittierende polymere oder niedermolekulare Verbindungen zugemischt sind, sind bekannt (z. B. Y. C. Kim et al., Polymeric Materials Science and Engineering 2002, 87, 286; T.-W. Lee et al., Synth. Metals 2001, 122, 437). Eine Zusammenfassung über solche Blends gibt S.-A. Chen et al., ACS Symposium Series 1999, 735 (Semiconducting Polymeres), 163. In US 2004/0033388 werden weiß emittierende Blends aus einem blau emittierenden Polymer mit zwei oder mehr niedermolekularen Emittern beschrieben, wobei die Dotanden in weniger als 0.1 Gew.% verwendet werden. Dabei sind extrem hohe Spannungen nötig, so dass ein solches System für die praktische Anwendung ohne Nutzen ist.
Alle diese Blends, unabhängig davon, ob es sich um Blends mit Polymeren oder niedermolekularen Verbindungen handelt, haben zwei entscheidende Nachteile: Die Polymere in Blends sind oft nicht ideal miteinander mischbar und neigen dadurch zu deutlich schlechterer Filmbildung und/oder Phasentrennung im Film. Die Bildung homogener Filme, wie sie für die Verwendung in Leuchtdioden essentiell sind, ist häufig nicht möglich. Außerdem besteht die Gefahr der Kristallisation oder der Migration der niedermolekularen Verbindung, was zu einer verringerten Langzeitstabilität führt. Auch eine Phasentrennung in der Vorrichtung bei längerem Betrieb wird beobachtet und führt zur Verringerung der Lebensdauer und zu Farbinstabilitäten. In Bezug auf weiß emittierende PLEDs ist die Farbreinheit und die Farbstabilität der Vorrichtung einer der wichtigsten Aspekte. Auch hier sind Blends im Nachteil, da die einzelnen Blendkomponenten unterschiedlich schnell altern ("differential ageing") und damit zu einer Farbverschiebung führen. Deshalb sind Blends im Vergleich zu Copolymeren allgemein weniger geeignet für die Verwendung in PLEDs.

Weiterhin sind weiß emittierende Copolymere bekannt, deren weiße Emission sich aus einer blau emittierenden Einheit im Polymer und einem rot verschoben emittierenden Aggregat dieser Einheiten zusammensetzt. Die Effizienz der Emission ist bei Verwendung solcher Polymere allerdings so gering, dass solche Polymere für die praktische Anwendung nicht brauchbar sind. Ein Beispiel für ein solches Copolymer gibt US 2003/00081751; die weiße Emission setzt sich hier zusammen aus der blauen Emission des Polymergrundgerüsts und der rot verschobenen Emission bestimmter Carbazolaggregate, die zu hohem Anteil mit einpolymerisiert sind. Hier werden zwar die Nachteile vermieden, die die oben genannten Blends mit sich bringen. Allerdings wird für ein Device mit einem solchen Polymer eine Einsatzspannung von 9 V und eine Effizienz von nur 0.06 cd/A angegeben. Es wird jedoch nicht gelehrt, wie man mit der vorgeschlagenen Polymerzusammensetzung höhere Effizienzen und reduzierte Einsatz- und Betriebsspannungen erreichen kann. Ein weiteres Beispiel geben K. L. Paik et al. (Optical Materials 2002, 21, 135). Auch hier beruht der rote Anteil der Emission auf einem Aggregat (Exciplex o. ä.). Der Nachteil ist auch hier deutlich zu sehen, da bei Spannungen unter 13 V die Emissionsfarbe blau ist und sich erst bei Spannungen über 13 V nach weiß verschiebt. Zhan et al. (Synth. Met. 2001, 124, 323) untersuchten ein weiß emittierendes Copolymer aus Diethinylfluoren und Thiophen-Einheiten, wobei auch hier ein Exciplex an der Emission beteiligt ist. Die externe Quanteneffizienz beträgt nur 0.01 %, und eine Elektrolumineszenz ist erst ab einer Spannung von 11 V nachweisbar. Ein weiß emittierendes Copolymer mit Oxadiazol, Phenylenvinylen und Alkylether-Einheiten wird beschrieben von Lee et a/. (Appl. Phys. Lett. 2001, 79, 308), wobei sich auch hier die Emission aus blauer Emission des Polymers und roter Emission eines angeregten Dimers zusammensetzt. Die maximale Effizienz beträgt nur 0.071 cd/A, die Betriebsspannungen sind sehr hoch und die Leuchtdiode zeigt eine große Abhängigkeit des Farborts von der Spannung.
Angesichts der hohen Spannungen und der schlechten Effizienzen in diesen Polymeren vermuten wir einen intrinsisch mit der Aggregat-Emission verbundenen Nachteil, nämlich, dass diese als Ladungsfänger (Traps) wirken. Diese Polymere sind alle für die technische Anwendung ungeeignet, da sie keine stabile weiße Emission über einen weiten Spannungsbereich zeigen, außerdem sehr schlechte Effizienzen zeigen und hohe Spannungen benötigen.

In US 2003/224208 werden nicht-konjugierte Polymere beschrieben, welche in die Seitenkette gebundene Triplett-Emitter enthalten. Es wird erwähnt, dass durch Verwendung mehrerer verschiedener Metallkomplexe in einem Polymer auch weiße Emission erzeugt werden kann. Jedoch wird hier nicht gezeigt, welche Metallkomplexe hier sinnvoll kombiniert werden können und vor allem in welchen Anteilen diese Komplexe im Polymer vorhanden sein müssen, so dass auch der Fachmann aus den Ausführungen keine Lehre ziehen kann, wie aus diesen Polymeren weiße Emission erzeugt werden könnte. Insbesondere sind in den Ausführungsbeispielen weiß emittierende Polymere nur als Mischungen (Blends) aus zwei Polymeren unterschiedlicher Emissionsfarbe beschrieben, so dass es naheliegt, dass hier weiße Emission aus einem einzelnen Polymer nicht einfach zu erzeugen ist.

In EP 1424350 werden phosphoreszierende Polymere beschrieben, die blaue, grüne und rote Triplett-Emitter bzw. blaue / grüne und gelbe / rote Triplett-Emitter enthalten und damit in Summe weiße Emission zeigen können. Wie oben wird jedoch auch hier nicht gezeigt, welche Metallkomplexe hier sinnvoll verwendet werden können und in welchen Anteilen, so dass es auch hier für den Fachmann nicht möglich ist, die beschriebenen Polymere für weiße Emission erfolgreich in die Praxis umzusetzen. In dem einzigen Ausführungsbeispiel zu weiß emittierenden Polymeren wird nur ein sehr geringer Anteil (1 mol%) eines blau emittierenden Monomers, zusammen mit grün und rot emittierenden Monomeren, in einer nicht-konjugierten Matrix aus Carbazol verwendet. Mit diesem Polymer wird zwar weiße Emission erhalten, jedoch sind weder Effizienz noch Betriebsspannung oder Lebensdauer angegeben, so dass vermutet werden muss, dass diese Eigenschaften hier noch nicht zufriedenstellend sind und dass daher ein so geringer Anteil eines blau emittierenden Monomers und eine nicht-konjugierte Matrix aus Carbazol nicht für gute Eigenschaften geeignet sind.

In WO 03/102109 werden weiß emittierende Copolymere beschrieben, die gleichzeitig Phosphoreszenz aus einem kovalent gebundenen Iridium-Komplex und Fluoreszenz aus der konjugierten Polymerhauptkette zeigen. Dabei wird ein Anteil des Triplett-Emitters von bevorzugt 0.01 bis 5 mol% angegeben. Alle Ausführungsbeispiele zeigen jedoch Polymeren, deren Anteil grün emittierender Triplett-Emitter bei 1 mol% und mehr, meist sogar bei 2 bis 4 mol%, liegt, so dass die Vermutung nahe liegt, dass der geringere Anteil nur zufällig aufgeführt ist. Es wird nicht ausgeführt, wie gezielt erreicht werden kann, dass die Polymere weiße Lumineszenz statt farbiger Phosphoreszenz zeigen, was ebenfalls in dieser Anmeldung mit dem gleichen Anteil derselben Monomere beschrieben ist, so dass auch der Fachmann keine Lehre daraus ziehen kann, welche Maßnahmen er zur Herstellung weiß emittierender Polymere ergreifen muss. So werden Beispiele aufgeführt, die sehr ähnliche Komplexe in gleicher Konzentration in ähnlichen Polymeren zeigen, wobei diese teilweise grüne oder rote Emission und in ähnlichen Fällen weiße Emission zeigen. Weiterhin ist erwähnt, dass die Kombination von Fluoreneinheiten mit rot emittierenden Triplett-Emittern immer zu vollständigem Energieübertrag und daher nicht zu weißer Emission führt. Dies legt nahe, dass so keine guten weiß emittierenden Polymere erhalten werden können, da der Rotanteil im Emissionsspektrum zu gering ist, wenn keine rot emittierenden Einheiten verwendet werden können. Die in den Ausführungsbeispielen beschriebenen Polymere zeigen zwar weiße Emission, jedoch ist die Effizienz in den wenigen Beispielen, in denen Elektrolumineszenzmessungen beschrieben sind, extrem niedrig und liegt im Bereich von weniger als 0.02 bis 0.2 cd/A bei Betriebsspannungen von ca. 12 V. Diese Polymere sind daher für die praktische Anwendung ungeeignet.

Aus dem oben beschriebenen Stand der Technik ist offensichtlich, dass es bislang noch keine Lösung gibt, wie hochwertige, weiß emittierende PLEDs erhalten werden können. Es besteht also weiterhin großer Bedarf an weiß emittierenden Polymeren, die gute Filmbildung zeigen, hohe Effizienzen und niedrige Betriebsspannungen aufweisen.

Überraschend wurde nun gefunden, dass die unten näher beschriebenen Copolymere sehr effiziente weiße Emission bei guten Farbkoordinaten und niedriger Betriebsspannung zeigen. Diese Polymere und deren Verwendung in PLEDs sind daher Gegenstand der vorliegenden Erfindung.

Gegenstand der Erfindung sind weiß emittierende Copolymere gemäß Anspruch 1. In dem oben beschriebenen Copolymer ergibt der Anteil aller vorhandenen Wiederholeinheiten, also der Einheiten **B**, der Einheiten **R**, der Einheiten **G** und gegebenenfalls weiterer Wiederhaleinheiten 100 mol%.

Weiße Emission ist definiert durch die CIE-Farbkoordinaten x = 0.33 und y = 0.33 (Chromatizitäts-Koordinaten der Commission Internationale de l'Eclairage von 1931). Der Farbeindruck kann jedoch individuell verschieden sein, so dass auch ein Wert, der in der Nähe dieses Bereiches liegt, immer noch den Eindruck weißer Emission hinterlassen kann. Unter weißer Emission im Sinne dieser Erfindung soll deshalb eine Emission verstanden werden, deren Farbkoordinaten innerhalb einer Ellipse liegen, die von den Punkten mit den x / y-Farbkoordinaten von (0.22 / 0.24), (0.46 / 0.44), (0.28 / 0.38) und (0.37 / 0.28) aufgespannt wird. Bevorzugt emittieren die erfindungsgemäßen Polymere weißes Licht, das durch einen Farbort im Chromatizitätsdiagramm gemäß CIE 1931 definiert ist, wobei die Farbkoordinate x Werte von 0.28 bis 0.38 und die Farbkoordinate y unabhängig von x Werte von 0.28 bis 0.38 annehmen kann.

Eine blau emittierende Wiederholeinheit **B** im Sinne dieser Erfindung ist so definiert, dass ein Film des Homopolymers dieser Einheit **B** Lumineszenz (Fluoreszenz oder Phosphoreszenz) zeigt und dass das Maximum der Emissionskurve eines Films eines Polymers, das 10 mol% dieser Einheit **B** und 90 mol% 2,7-[2',3',6',7'-tetra(2-methylbutyloxy)spirobifluoren]ylen enthält, in einem Wellenlängenbereich von 400 bis 490 nm liegt.
Eine grün emittierende Wiederholeinheit **G** im Sinne dieser Erfindung ist so definiert, dass das Maximum der Fluoreszenz- oder Phosphoreszenzkurve eines Films eines Polymers, das 10 mol% dieser Einheit **G** und 90 mol% 2,7-[2',3',6',7'-tetra(2-methylbutyloxy)spirobifluoren]ylen enthält, in einem Wellenlängenbereich von 490 bis 570 nm liegt.
Eine rot emittierende Wiederholeinheit **R** im Sinne dieser Erfindung ist so definiert, dass das Maximum der Fluoreszenz- oder Phosphoreszenzkurve eines Films eines Polymers, das 10 mol% dieser Einheit **R** und 90 mol% 2,7-[2',3',6',7'-tetra(2-methylbutyloxy)spirobifluoren]ylen enthält, in einem Wellenlängenbereich von 570 bis 700 nm liegt.
Es sei hier explizit darauf hingewiesen, dass auch Mischfarben, wie beispielsweise gelb oder orange im Sinne dieser Erfindung je nach ihrem Emissionsmaximum roter oder grüner Emission zugerechnet werden sollen.
Die Grenzen, bei denen ein Polymer noch weiße Emission zeigt, sind dabei nicht starr zu sehen. So ist es beispielsweise möglich, dass ein Polymer, das außer blau emittierenden Einheiten noch 0.0005 bis 1 mol% grüne Einheiten enthält, deren Emissionsmaximum nach der obigen Definition im Bereich von ca. 550 bis 570 nm liegt, immer noch weiße Emission mit guten Farbkoordinaten zeigt. Auch solche Polymere sind also Gegenstand der vorliegenden Erfindung.

In dem Copolymer liegt das Verhältnis von roten zu grünen Wiederhofeinheiten (Einheiten **R** : **G**) im Bereich von 1 : 20 bis 1 : 2.

Die erfindungsgemäßen Polymere sind konjugiert oder teilkonjugiert. Eine besonders bevorzugte Ausführungsform der Erfindung verwendet konjugierte Copolymere.
Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette.
Hauptsächlich meint, dass natürlich auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette beispielsweise Arylamineinheiten, Arylphosphineinheiten und/oder bestimmte Heterocyclen (d. h. Konjugation über N-, O- oder S-Atome) und/oder metallorganische Komplexe (d. h. Konjugation über das Metallatom) befinden. Hingegen würden Einheiten wie beispielsweise einfache (Thio)Etherbrücken, Alkylenbrücken, Ester-, Amid- oder Imidverknüpfungen eindeutig als nicht-konjugierte Segmente definiert. Unter einem teilkonjugierten Polymer im Sinne dieser Erfindung wird ein Polymer verstanden, das entweder in der Hauptkette längere konjugierte Abschnitte enthält, die durch nicht-konjugierte Abschnitte unterbrochen werden, oder das in den Seitenketten eines in der Hauptkette nicht-konjugierten Polymers längere konjugierte Abschnitte enthält.

Die unterschiedlichen Wiederholeinheiten des Copolymers können aus verschiedenen Gruppen ausgewählt sein. Diese Struktureinheiten und deren Synthesen sind ausführlich in WO 02/077060, in WO 03/020790, in DE 10337346.2 und der darin zitierten Literatur beschrieben.

Als blau emittierende Wiederholeinheiten **B** kommen typischerweise Einheiten in Frage, welche im Allgemeinen als Polymergrundgerüst ("Backbone") verwendet werden oder solche, welche als blaue Emitter verwendet werden. Dies sind im Allgemeinen solche, welche mindestens eine aromatische oder andere konjugierte Struktur aufweisen, aber die Emissionsfarbe nicht ins Grüne oder ins Rote verschieben. Beispiele hierfür sind aromatische Strukturen mit 4 bis 40 C-Atomen, aber auch Stilben- und Tolan-Derivate und gewisse Bis(styryl)arylen-Derivate. Dies sind beispielsweise folgende Strukturelemente, die substituiert, beispielsweise durch eine oder mehrere Gruppen mit 1 bis 40 C-Atomen, oder unsubstituiert sein können: 1,4-Phenylen-, 1,4-Naphthylen-, 1,4- oder 9,10-Anthracenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilbenderivate, 4,5-Dihydropyrenderivate, 4,5,9,'10-Tetrahydropyrenderivate, Fluorenderivate (z. B. gemäß EP 0842208, WO 99/54385, WO 00/22027, WO 00/22026, WO 00/46321), Spirobifluorenderivate (z. B. gemäß EP 0707020, EP 0894107, WO 03/020790, WO 02/077060), 5,7-Dihydrodibenzoxepinderivate und 9,10-Dihydrophenanthrenderivate (z. B. gemäß DE 10337346.2). Neben diesen Klassen kommen hier beispielsweise auch die so genannten Leiter-PPPs ("Ladder-PPPs" = LPPP) bzw. Ausschnitte aus solchen Polymeren (z. B. gemäß WO 92/18552), aber auch Ansa-Strukturen enthaltende PPPs (z. B. gemäß EP 690086) in Frage. Auch Bis(styryl)arylen-Derivate, die nicht elektronenreich sind, können hierfür verwendet werden. Es kann auch bevorzugt sein, wenn statt einer mehrere verschiedene solcher blau emittierenden Wiederholeinheiten **B** in einem Polymer verwendet werden.

Beispiele für grün emittierende Wiederholeinheiten **G** sind solche, die mindestens eine aromatische oder sonstige konjugierte Struktur aufweisen und die Emissionsfarbe ins Grüne verschieben. Bevorzugte Strukturen für grün emittierende Wiederholeinheiten **G** sind ausgesucht aus den Gruppen der elektronenreichen Bis-styrylarylene und Derivate dieser Strukturen. Ohne dabei an eine bestimmte Theorie gebunden sein zu wollen, vermuten wir, dass allgemein eine elektronenschiebende Substitution zu einer Grünverschiebung der Emission dieser Einheiten führt. Gemäß Anspruch 1 sind die grün emittierenden Wiederholeinheiten ausgewählt aus den Gruppen der Chinoxaline, der Phenothiazine, der Phenoxazine, der Dihydrophenazine, der Bis(thienyl)arylene, der Oligo(thienylene) und der Phenazine. Dabei ist es auch zulässig, dass statt einer grün emittierenden Wiederholeinheit **G** mehrere verschiedene solcher Wiederholeinheiten verwendet werden, wobei dann der Gesamtanteil der grün emittierenden Wiederholeinheiten **G** maximal 3 mol% beträgt. Besonders bevorzugte Strukturen, die sich als grün emittierende Wederholeinheiten **G** eignen, sind Strukturen gemäß Formeln (I), (II), (III), (V), (VI), (VIII) und (XII), die substituiert, beispielsweise durch eine oder mehrere organische Gruppen mit 1 bis 40 C-Atomen, oder unsubstituiert sein können, 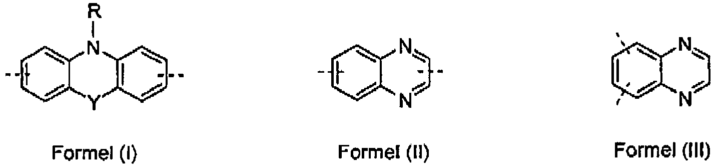 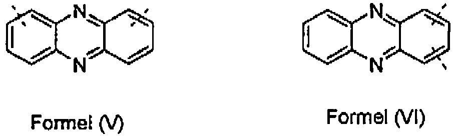 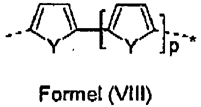 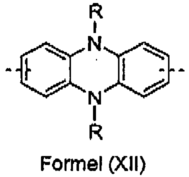 wobei für die verwendeten Symbole und Indizes gilt:
- Y: ist bei jedem Auftreten gleich oder verschieden S oder O;
- R: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O- oder -O-CO-O- ersetzt sein können, wobei auch ein oder mehrere H-Atome durch Fluor ersetzt sein können, oder eine substituierte oder unsubstituierte Arylgruppe mit 5 bis 40 C-Atomen, bei der auch ein oder mehrere C-Atome durch O, S oder N ersetzt sein können;
- p: ist bei jedem Auftreten gleich oder verschieden 1, 2, 3, 4 oder 5, bevorzugt 1, 2 oder 3;
dabei deuten die gestrichelten Bindungen die Verknüpfung im Polymer an; sie stehen hier nicht für eine Methylgruppe.

Als rot emittierende Wiederholeinheiten **R** kommen Einheiten in Frage, welche mindestens eine aromatische oder sonstige konjugierte Struktur aufweisen und die Emissionsfarbe ins Rote verschieben. Strukturen für rot emittierende Wiederholeinheiten **R** sind solche, in denen elektronenreiche Einheiten, wie beispielsweise Thiophen, mit grün emittierenden elektronenarmen Einheiten, wie beispielsweise Chinoxalin oder Benzothiadiazol, kombiniert sind. Weitere rot emittierende Wiederholeinheiten **R** sind Systeme aus mindestens vier, bevorzugt mindestens fünf, kondensierten, gegebenenfalls substituierten aromatischen Einheiten, wie beispielsweise Rubrene, Pentacene oder Perylene, die bevorzugt substituiert sind, oder konjugierte Push-Pull-Systeme (Systeme, die mit Donor- und Akzeptorsubstituenten substituiert sind) oder Systeme wie Squarine oder Chinacridone, die bevorzugt substituiert sind. Dabei ist es auch zulässig, dass statt einer rot emittierenden Wiederholeinheit **R** mehrere unterschiedliche solcher Wiederholeinheiten verwendet werden, wobei dann der Gesamtanteil der rot emittierenden Wiederholeinheiten **R** maximal 1 mol% beträgt.
Rot emittierende Wiederholeinheiten **R** sind Strukturen gemäß Formeln (XIII) bis (XIX), die substituiert, beispielsweise durch durch eine oder mehrere organische Gruppen mit 1 bis 40 C-Atomen, oder unsubstituiert sein können, 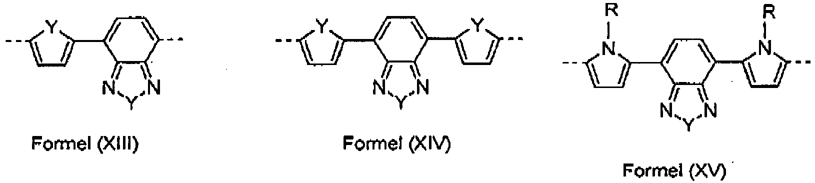 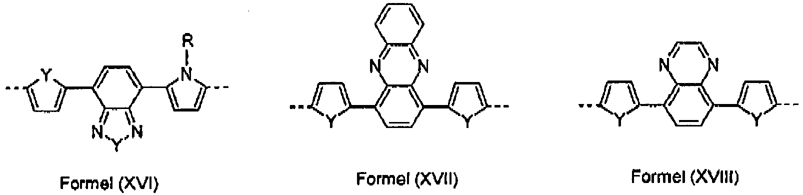 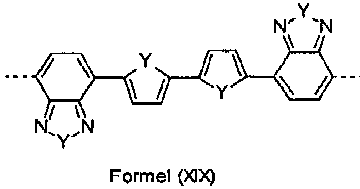 wobei die Symbole dieselbe Bedeutung haben, wie oben beschrieben.

Werden nur Singulett-Emitter für alle Emissionsfarben verwendet, so zeigt das Polymer nur Elektrofluoreszenz.

Weiterhin bevorzugt sind weiß emittierende Copolymere, die außer den genannten Wederholeinheiten weitere Wiederholeinheiten enthalten, die entweder keine Fluoreszenz zeigen oder deren Maximum der Fluoreszenzkurve in einem Wellenlängenbereich von 400 bis 490 nm liegt. Die Verwendung solcher Wiederholeinheiten kann beispielsweise sinnvoll sein, um den Lochtransport, die Lochinjektion, den Elektronentransport und/oder die Elektroneninjektion zu unterstützen. Im Sinne dieses Anmeldetextes soll unter solchen Strukturelementen Folgendes verstanden werden: Würde man aus diesen Strukturelementen Homopolymere oder-oligomere erzeugen, hätten diese, zumindest für einen Ladungsträger, d. h. entweder für Elektronen oder Löcher, eine höhere Ladungsträgermobilität, als dies bei einem Polymer der Fall ist, welches ausschließlich aus Strukturelementen besteht, welche oben als "blau emittierende" bzw. Backbone-Strukturen beschrieben sind. Bevorzugt ist die Ladungsträgermobilität (gemessen in cm²/(V·s)) mindestens um einen Faktor 10, besonders bevorzugt mindestens um einen Faktor 50 größer.

Wiederholeinheiten, die den Lochtransport und/oder die Lochinjektion verbessern, sind vorzugsweise ausgesucht auf den Gruppen der Triarylaminderivate, Triarylphosphinderivate, Benzidinderivate, Tetraarylen-para-phenylendiaminderivate, Thianthrenderivate, Dibenzo-*p-*dioxinderivate, Phenoxathiinderivate, Carbazolderivate, Azulenderivate, Thiophenderivate, Pyrrolderivate, Furanderivate und weiterer O-, S- oder N-haltiger Heterocyclen mit hoch liegendem HOMO (HOMO = höchst liegendes besetztes Molekülorbital); diese können jeweils substituiert, beispielsweise durch eine oder mehrere organische Gruppen mit 1 bis 40 C-Atomen, oder unsubstituiert sein. Bevorzugt führen diese Einheiten zu einem HOMO im Polymer von weniger als 5.8 eV (gegen Vakuum), besonders bevorzugt von weniger als 5.5 eV.

Strukturelemente, die den Elektronentransport und/oder die Elektroneninjektion verbessern, sind bevorzugt ausgesucht aus den Gruppen der Pyridinderivate, Pyrimidinderivate, Pyridazinderivate, Pyrazinderivate, Triarylborane, Oxadiazolderivate, Chinolinderivate, Triazinderivate und weiterer O-, S- oder N-haltiger Heterocyclen mit niedrig liegendem LUMO (LUMO = niedrigstes unbesetztes Molekülorbital); diese können substituiert, beispielsweise durch eine oder mehrere organische Gruppen mit 1 bis 40 C-Atomen, oder unsubstituiert sein. Bevorzugt führen diese Einheiten im Polymer zu einem LUMO von mehr als 2.7 eV (gegen Vakuum), besonders bevorzugt von mehr als 3.0 eV.

Weitere Strukturelemente können verwendet werden, um den Singulett-Triplett-Transfer im Polymer zu unterstützen. Solche Gruppen werden v. a. dann eingesetzt, wenn mindestens eine der rot, grün und/oder blau emittierenden Struktureinheiten einen Triplett-Emitter enthält. Bevorzugte Gruppen hierfür sind Carbazoleinheiten, insbesondere überbrückte Carbazoldimereinheiten, wie in den nicht offen gelegten Anmeldungen DE 10304819.7 und DE 10328627.6 beschrieben.

Überraschend wurde gefunden, dass stabile weiße Emission besonders gut mit einem unerwartet geringen Anteil an grün und rot emittierenden Wiederholeinheiten **G** und **R** erreicht wird.
Gemäß Anspruch 1 beträgt der Anteil blau emittierender Wiederholeinheiten **B** mindestens 50 mol%, der Anteil grün emittierender Wiederholeinheiten **G** 0.01 bis 0.5 mol%, der Anteil rot emittierender Wiederholeinheiten **R** 0.002 bis 0.1 mol%, insbesondere 0.002 bis 0.05 mol%, und das Verhältnis der rot emittierenden Wiederholeinheiten zu grün emittierenden Wiederholeinheiten (Einheiten **R : G**) liegt im Bereich von 1 : 20 bis 1 : 2.
Es kann auch bevorzugt sein, wenn der Anteil blau emittierender Wiederholeinheiten **B** im Polymer bis zu 99 mol% und mehr beträgt.
Ohne damit an eine spezielle Theorie gebunden sein zu wollen, vermuten wir, dass der überraschend gute partielle Energieübertrag von blau auf grün und von grün auf rot und der daraus folgende überraschend geringe Anteil an rot und grün emittierenden Einheiten in konjugierten Polymeren durch eine hohe Konjugation entlang der Polymerkette erzeugt wird. In Polymer-Blends liegen die Anteile des rot emittierenden Polymers (und falls vorhanden des grün emittierenden Polymers) häufig deutlich höher.

Die erfindungsgemäßen Polymere weisen in der Regel 10 bis 10000, bevorzugt 50 bis 5000, besonders bevorzugt 50 bis 2000 Wiederholeinheiten auf.

Die erfindungsgemäßen Copolymere können statistische oder blockartige Strukturen aufweisen oder auch mehrere dieser Strukturen abwechselnd besitzen. Wie Copolymere mit blockartigen Strukturen erhalten werden können, ist beispielsweise ausführlich in der nicht offen gelegten Anmeldung DE 10337077.3 beschrieben. Auch ist es möglich, bestimmte Einheiten, beispielsweise rot und/oder grün emittierende Einheiten, als Endgruppe an die Polymerkettenenden einzubauen. Durch das Verwenden verschiedener Strukturelemente können Eigenschaften wie Löslichkeit, Festphasenmorphologie, Farbe, Ladungsinjektions- und -transporteigenschaften, elektrooptische Charakteristik, etc. eingestellt werden.

Die erfindungsgemäßen Polymere werden in der Regel durch Polymerisation der Monomere hergestellt. Die Art der Polymerisationsreaktion ist nicht entscheidend. Es haben sich hier jedoch, insbesondere für konjugierte Polymere, einige Typen besonders bewährt, die alle zu C-C-Verknüpfungen führen:
(A) Polymerisation gemäß SUZUKI,
(B) Polymerisation gemäß YAMAMOTO,
(C) Polymerisation gemäß STILLE.

Wie die Polymerisation nach diesen Methoden durchgeführt werden kann und wie die Polymere vom Reaktionsmedium abgetrennt und aufgereinigt werden können, ist beispielsweise im Detail in WO 04/037887 beschrieben. Nach diesen Methoden kann auch die Synthese teilkonjugierter oder nicht-konjugierter Polymere durchgeführt werden, indem entsprechende Monomere verwendet werden, die nicht durchgängig konjugiert sind- Für teilkonjugierte oder nicht-konjugierte Polymere kommen aber auch andere Synthesemethoden in Frage, wie sie allgemein aus der Polymerchemie geläufig sind, wie beispielsweise allgemein Polykondensationen oder Polymerisationen, die beispielsweise über die Reaktion von Alkenen ablaufen und zu Polyethylen-Derivaten im weitesten Sinne führen, die dann die Chromophore in den Seitenketten gebunden enthalten.

Die erfindungsgemäßen Copolymere weisen gegenüber den oben genannten weiß emittierenden Polymer-Blends und den oben genannten weiß emittierenden Copolymeren folgende überraschende Vorteile auf:
(1) Die erfindungsgemäßen Copolymere bilden deutlich homogenere Filme im Vergleich zu Polymer-Blends gemäß Stand der Technik. Sie lassen keine Phasenseparation erkennen und sind daher auch langlebiger in ihrer Anwendung. Daher sind sie besser für die Verwendung in PLEDs geeignet.
(2) Die erfindungsgemäßen Copolymere weisen deutlich höhere Leuchteffizienzen und deutlich niedrigere Betriebsspannungen in der Anwendung auf, insbesondere im Vergleich zu Polymeren, deren weiße Emission auf Aggregaten beruht. Aber auch im Vergleich zu Polymeren, die gleichzeitig Fluoreszenz und Phosphoreszenz zeigen, wie beispielsweise in WO 03/102109 beschrieben, bei denen der Anteil des grünen Emitters deutlich höher ist als bei den erfindungsgemäßen Polymeren, ist die Effizienz um einen Faktor von bis zu mehr als 50 höher. Dies ist von enormer Bedeutung, da somit entweder gleiche Helligkeit bei geringerem Energieverbrauch erzielt werden kann, was vor allem bei mobilen Applikationen (Displays für Handys, PDA, etc.), die auf Batterien und Akkus angewiesen sind, wichtig ist. Umgekehrt erhält man bei gleichem Energieverbrauch höhere Helligkeiten, was beispielsweise für Beleuchtungsanwendungen interessant ist.
(3) Die Zugänglichkeit von reiner weißer Emission ist bei den erfindungsgemäßen Copolymeren mindestens gleichwertig oder besser als der Stand der Technik. Insbesondere verschiebt sich bei den erfindungsgemäßen Copolymeren der Farbpunkt nur geringfügig in Abhängigkeit der Betriebsspannung oder in Abhängigkeit der Betriebsdauer, was keinesfalls erwartungsgemäß und damit überraschend ist. Dies ist essentiell für die Anwendung dieser Copolymere.
(4) Die Effizienz bleibt auch bei hohen Spannungen und damit hohen Helligkeiten fast konstant, wodurch diese Polymere auch für Verwendung in Anzeigeelementen mit so genannter Passiv-Matrix-Ansteuerung geeignet sind.

Es kann außerdem bevorzugt sein, die erfindungsgemäßen Polymere nicht als Reinsubstanz, sondern als Mischung (Blend) zusammen mit weiteren beliebigen polymeren, oligomeren, dendritischen oder niedermolekularen Substanzen zu verwenden. Diese können beispielsweise den Ladungstransport und/oder das Ladungsgleichgewicht verbessern oder den Transfer vom Singulett- zum Triplettzustand beeinflussen oder selber emittieren. So kann es beispielsweise bevorzugt sein, in ein Polymer, das blau und rot emittierende Einheiten enthält, noch grün emittierende Verbindungen einzumischen, um den Grün-Anteil im Spektrum zu erhöhen. Aber auch elektronisch inaktive Substanzen können sinnvoll sein, um beispielsweise die Morphologie des gebildeten Polymerfilms oder die Viskosität von Polymerlösungen zu beeinflussen. Solche Blends sind daher auch Bestandteil der vorliegenden Erfindung.

Gegenstand der Erfindung sind weiterhin Lösungen und Formulierungen aus einem oder mehreren erfindungsgemäßen Copolymeren oder Blends in einem oder mehreren Lösungsmitteln. Wie Polymerlösungen hergestellt werden können, ist beispielsweise in WO 02/072714, in WO 03/019694 und in der darin zitierten Literatur beschrieben. Diese Lösungen können verwendet werden, um dünne Polymerschichten herzustellen, zum Beispiel durch Flächenbeschichtungsverfahren (z. B. Spin-coating) oder durch Druckverfahren (z. B. InkJet Printing, Siebdruck, etc.).

Die erfindungsgemäßen Copolymere und Blends können in PLEDs verwendet werden. Wie PLEDs hergestellt werden können, wird als allgemeines Verfahren ausführlich in WO 04/037887 beschrieben, das entsprechend für den Einzelfall anzupassen ist. Wie oben beschrieben, eignen sich die erfindungsgemäßen Polymere ganz besonders als Elektrolumineszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Copolymers oder Blends in einer PLED, insbesondere als Elektrolumineszenzmaterial. Bevorzugt werden die erfindungsgemäßen Copolymere in der emittierenden Schicht verwendet.

Gegenstand der Erfindung ist somit ebenfalls eine PLED mit einer oder mehreren aktiven Schichten, wobei mindestens eine dieser aktiven Schichten ein oder mehrere erfindungsgemäße Polymere oder Blends enthält. Die aktive Schicht kann beispielsweise eine lichtemittierende Schicht und/oder eine Ladungstransportschicht und/oder eine Ladungsinjektionsschicht sein, bevorzugt eine lichtemittierende Schicht.

Eine Ausführungsform der Erfindung ist die Verwendung einer erfindungsgemäßen PLED in einem monochrom weiß emittierenden Display.
Eine weitere Ausführungsform der Erfindung ist die Verwendung einer erfindungsgemäßen PLED in einem monochrom farbigen, mehrfarbigen oder vollfarbigen Display, wobei die Farbe durch Verwendung eines Farbfilters auf der weiß emittierenden PLED erzeugt wird-Eine weitere Ausführungsform der Erfindung ist die Verwendung einer erfindungsgemäßen PLED für Beleuchtungszwecke.
Eine weitere Ausführungsform der Erfindung ist die Verwendung einer erfindungsgemäßen PLED als Backlight in einem Flüssigkristall-Display (LCD).

Gegenstand der Erfindung sind also weiterhin weiß emittierende Displays enthaltend eine erfindungsgemäße PLED, farbige, mehrfarbige oder vollfarbige Displays unter Verwendung eines Farbfilters auf einer erfindungsgemäßen PLED, Beleuchtungselemente, enthaltend eine erfindungsgemäße PLED, und Flüssigkristall-Displays, enthaltend als Backlight eine erfindungsgemäße PLED.

Im vorliegenden Anmeldetext und auch in den im Weiteren folgenden Beispielen wird auf die Verwendung erfindungsgemäßer Polymere oder Blends in Bezug auf PLEDs und die entsprechenden Displays abgezielt. Diese Erfindung kann ohne weiteres erfinderisches Zutun beispielsweise auch auf weiß emittierende Dendrimere oder Oligomere übertragen werden. Ebenso ist es für den Fachmann ohne erfinderisches Zutun möglich, die erfindungsgemäßen Polymere oder Blends auch für weitere Verwendungen in anderen elektronischen Devices (Vorrichtungen) zu benutzen, z. B. für organische Solarzellen (O-SCs), organische Laserdioden (O-Laser), organische integrierte Schaltungen (O-ICs), in organischen Feld-Effekt-Transistoren (O-FETs) oder in organischen Dünnfilmtransistoren (O-TFTs), um nur einige Anwendungen zu nennen. Die Verwendung der erfindungsgemäßen Polymere oder Blends in den entsprechenden Vorrichtungen ebenso wie die Vorrichtungen selbst sind ebenfalls ein Gegenstand der vorliegenden Erfindung.

Die vorliegende Erfindung wird durch die folgenden Beispiele näher erläutert, ohne sie darauf einschränken zu wollen. Der Fachmann kann aus der Beschreibung und den aufgeführten Beispielen ohne weiteres erfinderisches Zutun weitere erfindungsgemäße organische Halbleiter herstellen und diese in organsichen elektronischen Vorrichtungen anwenden.

### Beispiele

### Beispiel 1: Monomersynthesen

Die Strukturen der für die erfindungsgemäßen Polymere verwendeten Monomere sind im Folgenden abgebildet. Ebenso ist deren Emissionsfarbe im Polymer (gemäß der Definition in der Beschreibung) notiert. Die Synthesen sind in WO 03/020790 und in DE 10337346.2 beschrieben.

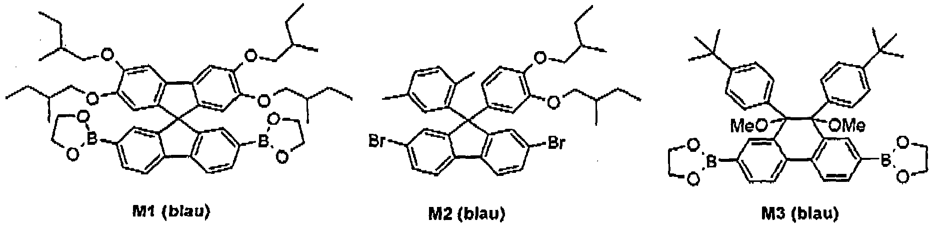

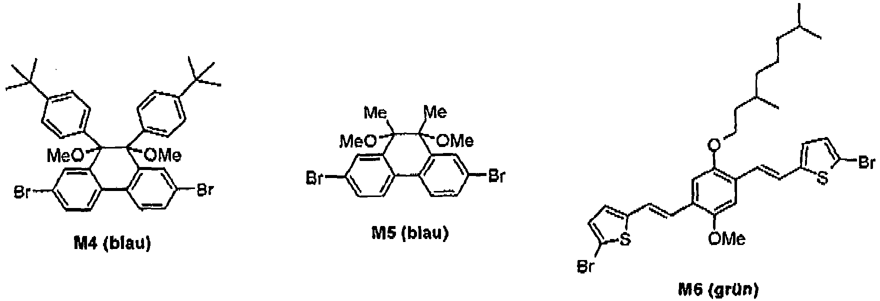

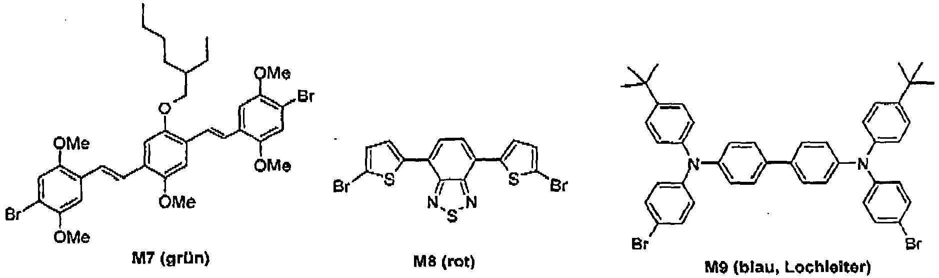

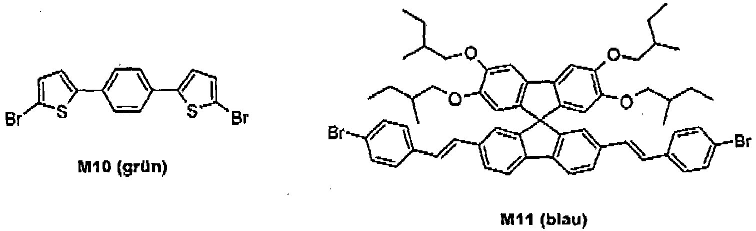

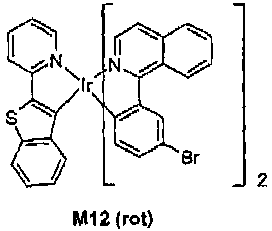

### Beispiel 2: Polymersynthesen

Die Polymere wurden durch SUZUKI-Kupplung gemäß WO 03/048225 synthetisiert. Die Zusammensetzung der synthetisierten Polymere P1 bis P9 (Beispiele 4 bis 12) ist in Tabelle 1 zusamrnengefasst.

### Beispiel 3: Herstellung der PLEDs

Alle Polymere wurden für einen Einsatz in PLEDs untersucht. Die PLEDs waren jeweils Zweischichtsysteme, d. h. Substrat//ITO//PEDOT//Polymer//Kathode. PEDOT ist ein Polythiophen-Derivat (von H. C. Starck, Goslar). Als Kathode wurde in allen Fällen Ba/Ag (von Aldrich) verwendet. Wie PLEDs dargestellt werden können, ist bereits in WO 04/037887 und der darin zitierten Literatur ausführlich beschrieben.
Die wichtigsten Device-Eigenschaften der erfindungsgemäßen Polymere (Farbe, Effizienz, Betriebsspannung, Lebensdauer) sind in Tabelle 1 aufgeführt.
Wie leicht aus diesen Angaben zu erkennen ist, übertrifft die Effizienz aller erfindungsgemäßen Polymere die Effizienz der Copolymere gemäß dem Stand der Technik um ein Vielfaches, und auch die Betriebsspannungen sind deutlich niedriger. So ist beispielsweise für das Copolymer in US 2003/00081751 eine Effizienz von 0.06 cd/A angegeben, was erkennen lässt, dass die erfindungsgemäßen Copolymere den Stand der Technik um einen Faktor von bis zu mehr als 100 übertreffen. Für dieses Polymer gemäß dem Stand der Technik ist eine Einsatzspannung von 9 V angegeben, während die erfindungsgemäßen Polymere bei 100 cd/m² in der Regel Spannungen in der Größenordnung von nur 4 - 5 V aufweisen. Ebenso ist die Effizienz ein Vielfaches höher als bei Polymeren gemäß dem Stand der Technik, die einen deutlich höheren Anteil eines grün phosphoreszierenden Emitters enthalten (WO 03/102109) und insgesamt weiße Emission zeigen.

**Tabelle 1: Beispiele 4 bis 12: Eigenschaften verschiedener erfindungsgemäßer weiß emittierender Copolymere P1 bis P9.**

| | | **Anteil der Monomere in der Polymerisation [mol%]** | | | | | | | | | | **GPC^{a}** | | **Elektrolumineszenz** | | | |
|---|---|---|---|---|---|---|---|---|---|---|---|---|---|---|---|---|---|
| **Bsp.** | **Poly.** | **M1** | **M2** | **M3** | **M4** | **M5** | **M6** | **M7** | **M8** | **M9** | **Weiteres Monomer** | M_{w} | Mₙ | Max. Eff.^{b} [cd/A] | U^{c} [V] | CIE-Koordinaten^{d} | Lebens-dauer^{e} [h] |
| **4** | **P1** | 50 | 39.88 | | | 0.1 | 0.1 | | 0.02 | 10 | | 672 | 225 | 7.89 | 4.4 | 0.37/0.39 | 1100 |
| **5** | **P2** | 50 | 39.88 | 39.88 | | | | 0.1 | 0.02 | 10 | | 853 | 125 | 6.50 | 4.2 | 0.32/0.32 | 450 |
| **6** | **P3** | | | 50 | 39.88 | | 0.1 | | 0.02 | 10 | | 95 | 37 | 5.20 | 5.6 | 0.36/0.38 | 450 |
| **7** | **P4** | 50 | | | | 39.88 | 0.1 | | 0.02 | 10 | | 317 | 101 | 8.25 | 4.2 | 0.40/0.41 | 2500 |
| **8** | **P5*** | 50 | 29.98 | | | | | | 0.02 | 10 | 10 **M11** | 501 | 152 | 5.02 | 4.3 | 0.31/0.32 | 750 |
| **9** | **P6** | 50 | 29.94 | | | | 0.05 | | 0.01 | 10 | 10 **M11** | 762 | 108 | 7.85 | 4.1 | 0.37/0.42 | 1400 |
| **10** | **P7** | 50 | 39.88 | | | | | | 0.02 | 10 | 0.1 **M10** | 983 | 201 | 4.69 | 4.5 | 0.30/0.27 | n. d. |
| **11** | **P8*** | 50 | 39.86 | | | | 0.1 | | | 10 | 0.02 **M12** | 283 | 105 | 7.16 | 4.0 | 0.32/0.44 | 1600 |
| **12** | **P9** | 50 | 29.88 | | | | 0.1 | | 0.02 | 10 | 10 **M11** | 624 | 146 | 8.06 | 3.9 | 0.43/0.44 | 10000 |

| | | | | | | | | | | | | | | | | | |
|---|---|---|---|---|---|---|---|---|---|---|---|---|---|---|---|---|---|
| ^{a} GPC Messungen: THF; 1 mL/min, Plgel 10µm Mixed-B 2 x 300 x 7.5 mm², 35 °C, RI Detektion gegen Polystyrol geeicht; Angabe in kDa. ^{b} Max. Eff.: Maximale Effizienz, gemessen in cd/A. ^{c} Spannung bei einer Helligkeit von 100 cd/m². ^{d} CIE-Koordinsten: Farbkoordinaten der Commision Internationale de l'Eclairage 1931. ^{e} Lebensdauer Zeit bis zum Abfall der Helligkeit auf 50 % der Anfangshelligkeit (extrapoliert auf eine Anfangsheltigkeit von 100 cd/m²). * nicht erfindungsgemäß | | | | | | | | | | | | | | | | | |

### Beispiel 13: Abhängigkeit der Emissionsfarbe von der Helligkeit

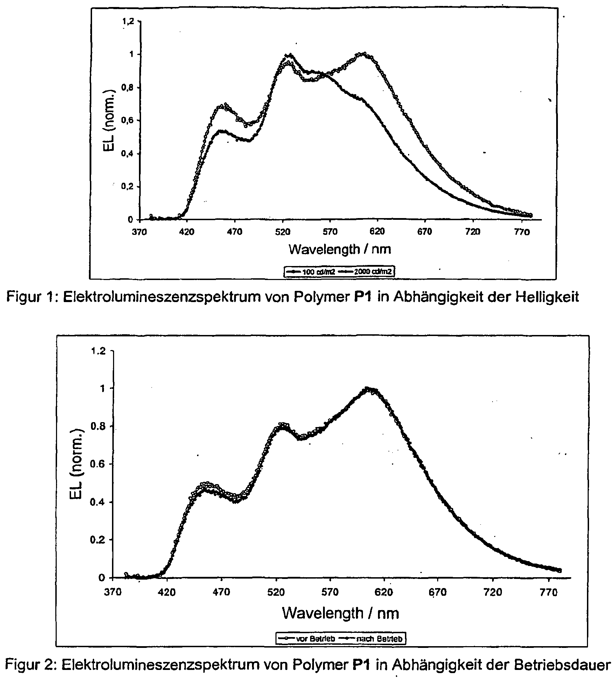

Für Polymer P1 (Beispiel 4) wurde die Emissionsfarbe in Abhängigkeit der Helligkeit für zwei unterschiedliche Helligkeiten (100 cd/m² und 2000 cd/m²) gemessen. Für die praktische Anwendung ist es wichtig, dass sich die Farbe in Abhängigkeit der Helligkeit nur wenig ändert. Die erhaltenen Elektrolumineszenzspektren sind in Figur 1 gezeigt:
Man sieht, dass bei höherer Helligkeit die Emission im roten Bereich des Spektrums zwar etwas abnimmt, aber diese Farbverschiebung ist gering (Verschiebung der Farbkoordinaten von x/y 0.37 / 0.39 bei 100 cd/m² zu x/y 0.35 / 0.42 bei 2000 cd/m²). Diese Farbverschiebung kann toleriert werden, und das Polymer kann als überwiegend farbkonstant in Abhängigkeit der Helligkeit bzw. der Betriebsspannung angesehen werden. Dies ist ein deutlicher Vorteil im Vergleich zu Copolymeren gemäß dem Stand der Technik. So wird beispielsweise in K. L. Paik et al., Optical Materials 2002, 21, 135 ein Polymer beschrieben, das bei Spannungen über 13 V (was an sich schon für die praktische Anwendung unbrauchbar ist) weiße Emission zeigt, während unterhalb dieser Spannung die Emissionsfarbe blau ist, das also eine extreme Abhängigkeit der Emissionsfarbe von der Betriebsspannung (und somit auch von der Helligkeit) zeigt.

### Beispiel 14: Emissionsfarbe in Abhängigkeit der Betriebsdauer

Für Polymer **P1** (Beispiel 4) wurde die Emissionsfarbe in Abhängigkeit der Betriebsdauer bestimmt. Dafür wurde das Elektrolumineszenzspektrum einer frisch gebauten PLED gemessen. Dann wurde die PLED bei konstanter Stromdichte (10 mA/cm²) so lange betrieben, bis die Helligkeit auf 50 % der Anfangshelligkeit abgefallen war, und das Elektrolumineszenzspektrum wurde erneut gemessen. Die beiden Spektren sind in Figur 2 gezeigt:
Dabei sieht man, dass das Spektrum in Abhängigkeit der Betriebsdauer praktisch unverändert ist (Verschiebung der x/y-Farbkoordinaten von 0.37 / 0.39 vor Betrieb zu 0.38 / 0.40 nach Betrieb), die Emissionsfarbe also konstant über die Betriebsdauer ist. Dies ist ein weiterer essenzieller Aspekt für die praktische Anwendbarkeit des Polymers. Auch hier bieten die erfindungsgemäßen Polymere einen entscheidenden Vorteil gegenüber Polymeren und insbesondere Blends gemäß dem Stand der Technik. Gerade Blends sind dafür bekannt, dass die einzelnen Blendkomponenten im Betrieb unterschiedlich schnell altem ("differential ageing"), so dass sich während der Betriebsdauer die Farbe oft beträchtlich verschiebt. Solche Blends sind für die praktische Anwendung deshalb nicht zu gebrauchen. So zeigt beispielsweise ein weiß emittierender Blend aus einem blauen Polymer (enthaltend 50 mol% **M1,** 37.5 mol% **M2** und 12.5 mol% **M9),** dem 0.4 % eines orange PPV (Polyphenylenvinylen) zugemischt wurden, die anfänglichen x/y-Farbkoordinaten von 0.29 0.37. Diese Farbe verschiebt sich nach Betrieb der PLED zu den Farbkoordinaten 0.36 / 0.45. Eine solche Farbverschiebung ist in der Anwendung nicht zu tolerieren.

## Patentansprüche

1. Weiß emittierende, konjugierte oder teilkonjugierte Copolymere, enthaltend mindestens drei verschiedene Wiederholeinheiten, **dadurch gekennzeichnet, dass** die erste Wiederholeinheit, Einheit **B**, in einem Anteil von mindestens 50 mol% vorliegt und blaue Emission zeigt, die zweite Wiederholeinheit, Einheit **G**, in einem Anteil von 0.01 bis 0.5 mol% im Polymer vorliegt und grüne Emission zeigt und die dritte Wiederholeinheit, Einheit **R**, in einem Anteil von 0.002 bis 0,1 mol% vorliegt und rote Emission zeigt, und das Verhältnis der rot emittierenden Wiederholeinheiten zu grün emittierenden Wiederholeinheiten (Einheiten **R : G**) im Bereich von 1 : 20 bis 1 : 2 liegt,
wobei blaue Emission der Wiederholeinheit **B** bedeutet, dass ein Film des Homopolymers dieser Einheit **B** Lumineszenz zeigt und dass das Maximum der Emissionskurve eines Films eines Polymers, das 10 mol% dieser Einheit **B** und 90 mol% 2,7-[2',3',6',7'-tetra(2-methylbutyloxy)spirobifluoren]ylen enthält, in einem Wellenlängenbereich von 400 bis 490 nm liegt,
wobei grüne Emission der Wiederholeinheit **G** bedeutet, dass das Maximum der Fluoreszenz- oder Phosphoreszenzkurve eines Films eines Polymers, das 10 mol% dieser Einheit **G** und 90 mol% 2,7-[2',3',6',7'-tetra(2-methylbutyloxy)spirobifluoren]ylen enthält, in einem Wellenlängenbereich von 490 bis 570 nm liegt
und wobei rote Emission der Wiederholeinheit **R** bedeutet, dass das Maximum der Fluoreszenz- oder Phosphoreszenzkurve eines Films eines Polymers, das 10 mol% dieser Einheit **R** und 90 mol% 2,7-[2',3',6',7'-tetra(2-methylbutyloxy)-spirobifluoren]ylen enthält, in einem Wellenlängenbereich von 570 bis 700 nm liegt,
und wobei
die blau emittierende Wiederholeinheit **B** ausgewählt ist aus den Strukturelementen der 1,4-Phenylen-, 1,4-Naphthylen-, 9,4- oder 9,10-Anthracenylen-, 1,6- oder 2,7- oder 4,9-Pyrenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilbenderivate, 4,4'-Tolanderivate, 4,5-Dihydropyrenderivate, 4,5,9,10-Tetrahydropyrenderivate, Fluorenderivate, Spirobifluorenderivate, 5,7-Dihydrodibenzoxepinderivate, 9,10-Dihydrophenanthrenderivate und Bis(styryl)arylene, die substituiert oder unsubstituiert sein können;
und wobei
die rot emittierenden Wiederholeinheiten **R** ausgesucht sind aus den Einheiten gemäß Formel (XIII) bis (XIX), die substituiert oder unsubstituiert sein können: 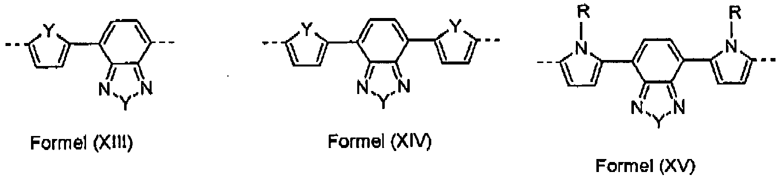 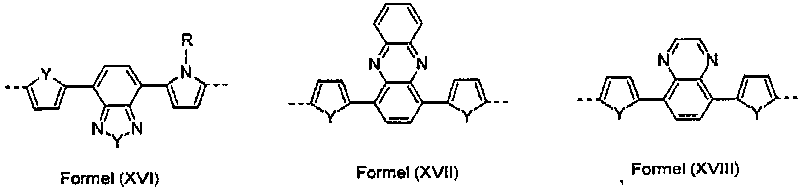 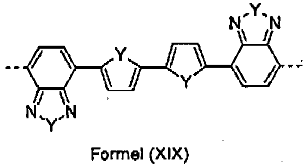 wobei für die verwendeten Symbole und Indizes Folgendes gilt:
Y ist bei jedem Auftreten gleich oder verschieden S oder O;
R ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O- oder -O-CO-O- ersetzt sein können, wobei auch ein oder mehrere H-Atome durch Fluor ersetzt sein können, oder eine substituierte oder unsubstituierte Arylgruppe mit 5 bis 40 C-Atomen, bei der auch ein oder mehrere C-Atome durch O, S oder N ersetzt sein können; dabei deuten die gestrichelten Bindungen die Verknüpfung im Polymer an;
und wobei
die grün emittierende Wiederholeinheit **G** ausgesucht ist aus den Gruppen der elektronenreichen Bis(styryl)arylene und entsprechender erweiterter Strukturen, der Chinoxaline, der Phenothiazine, der Dihydrophenazine, der Bis(thienyl)arylene, der Oligo(thienylene), der Phenazine und entsprechender Derivate, die Sauerstoff statt Schwefel enthalten

2. Copolymere gemäß Anspruch 1, **dadurch gekennzeichnet, dass** die grün emittierenden Wiederholeinheiten **G** ausgesucht sind aus den Einheiten gemäß Formel (I) bis (III), (V), (VI), (VIII) und (XII), die substituiert oder unsubstituiert sein können: 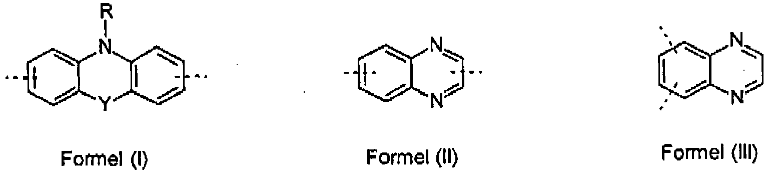 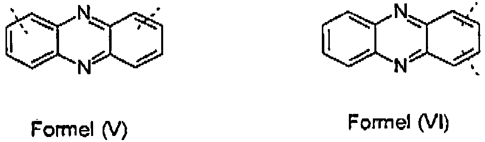 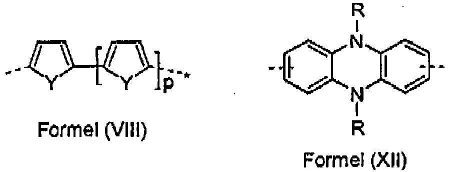 wobei für die verwendeten Symbole und Indizes Folgendes gilt:
Y ist bei jedem Auftreten gleich oder verschieden S oder O;
R ist bei jedem Auftreten gleich oder verschieden H. eine geradkettige, verzweigte oder cyclische Alkylkette mit 1 bis 22 C-Atomen, in der auch ein oder mehrere nicht benachbarte C-Atome durch O, S, -CO-O- oder -O-CO-O- ersetzt sein können, wobei auch ein oder mehrere H-Atome durch Fluor ersetzt sein können, oder eine substituierte oder unsubstituierte Arylgruppe mit 5 bis 40 C-Atomen, bei der auch ein oder mehrere C-Atome durch O, S oder N ersetzt sein können;
p ist bei jedem Auftreten gleich oder verschieden 1, 2, 3, 4 oder 5;
dabei deuten die gestrichelten Bindungen die Verknüpfung im Polymer an.

3. Copolymere gemäß einem oder mehreren der Ansprüche 1 oder 2, **dadurch gekennzeichnet, dass** sie zusätzliche Wiederholeinheiten enthalten, die die Lochinjektion und/oder den Lochtransport verbessern und ausgewählt sind aus den Gruppen der Triarylaminderivate, Triarylphosphinderivate, Benzidinderivate, Tetraarylen-para-phenylendiaminderivate, Thianthrenderivate, Dibenzo-*p*-dioxinderivate, Phenoxathiinderivate, Carbazolderivate, Azulenderivate, Thiophenderivate, Pyrrolderivate, Furanderivate und weiterer O-, S- oder N-haltiger Heterocyclen mit hoch liegendem HOMO.

4. Copolymere gemäß einem oder mehreren der Ansprüche 1 bis 3, **dadurch gekennzeichnet, dass** die zusätzlichen Wiederholeinheiten die Elektroneninjektion und/oder den Elektronentransport verbessern und ausgewählt sind aus den Gruppen der Pyridinderivate, Pyrimidinderivate, Pyridazinderivate, Pyrazinderivate, Triarylborane, Oxadiazolderivate, Chinolinderivate, Triazinderivate und weiterer O-, S- oder N-haltiger Heterocyclen mit niedrig liegendem LUMO.

5. Copolymere gemäß einem oder mehreren der Ansprüche 1 bis 4, **dadurch gekennzeichnet, dass** die Einheiten den Singulett-Triplett-Transfer im Polymer unterstützen und ausgewählt sind aus den Gruppen der Carbazole und der überbrückten Carbazole.

6. Blends enthaltend mindestens ein Copolymer gemäß einem oder mehreren der Ansprüche 1 bis 5 und mindestens eine weitere polymere, oligomere, dendritische oder niedermolekulare Verbindung.

7. Lösungen und Formulierungen aus ein oder mehreren Copolymeren oder Blends gemäß einem oder mehreren der Ansprüche 1 bis 6 in einem oder mehreren Lösungsmitteln.

8. Verwendung eines Copolymers oder Blends gemäß einem oder mehreren der Ansprüche 1 bis 6 in einer polymeren lichtemittierenden Diode (PLED) als Elektrolumineszenzmaterial.

9. Polymere lichtemittierende Diode (PLED) mit einer oder mehreren aktiven Schichten, wobei mindestens eine dieser aktiven Schichten ein Copolymer oder Blend gemäß einem oder mehreren der Ansprüche 1 bis 6 enthält.

10. Weiß emittierendes Display enthaltend eine PLED gemäß Anspruch 9.

11. Farbiges, mehrfarbiges oder vollfarbiges Display, wobei die Farbe durch Verwendung eines Farbfilters auf einer weiß emittierenden PLED gemäß Anspruch 9 erzeugt wird.

12. Beleuchtungselement enthaltend eine PLED gemäß Anspruch 9.

13. Flüssigkristall-Display (LCD), enthaltend als Backlight eine weiß emittierende PLED gemäß Anspruch 9 und/oder 10.

14. Verwendung eines Copolymers oder Blends gemäß einem oder mehreren der Ansprüche 1 bis 6 in einer organischen Solarzelle, organischen Laserdiode, organischen integrierten Schaltung, einem organischem Feld-Effekt-Transistor oder einem organischen Dünnfilmtransistor.

15. Organische Solarzelle, organische Laserdiode, organische integrierte Schaltung, organischer Feld-Effekt-Transistor oder organischer Dünnfilmtransistor, enthaltend mindestens ein Polymer oder Blend gemäß einem oder mehreren der Ansprüche 1 bis 6.

## Claims

1. White-emitting, conjugated or partly conjugated copolymers, containing at least three different recurring units, **characterised in that** the first recurring unit, unit **B,** is present in a proportion of at least 50 mol% and exhibits blue emission, the second recurring unit, unit **G**, is present in the polymer in a proportion of 0.01 to 0.5 mol% and exhibits green emission and the third recurring unit unit **R,** is present in a proportion of 0.002 to 0.1 mol% and exhibits red emission, and the ratio of the red-emitting recurring units to green-emitting units (units **R : G**) is in the range from 1 : 20 to 1 : 2,
where blue emission of the recurring unit **B** means that a film of the homopolymer of this unit **B** exhibits luminescence and that the maximum of the emission curve of a film of a polymer which contains 10 mol% of this unit **B** and 90 mol% of 2,7-[2',3',6',7'-tetra(2-methylbutyloxy)spirobifluoren]ylene is in a wavelength range from 400 to 490 nm, where green emission of the recurring unit **G** means that the maximum of the fluorescence or phosphorescence curve of a film of a polymer which contains 10 mol% of this unit **G** and 90 mol% of 2,7-[2',3',6',7'-tetra(2-methylbutyloxy)spirobifluoren]ylene is in a wavelength range from 490 to 570 nm
and where red emission of the recurring unit **R** means that the maximum of the fluorescence or phosphorescence curve of a film of a polymer which contains 10 mol% of this unit **R** and 90 mol% of 2,7-[2',3',6',7-tetra(2-methylbutyloxy)spirobifluoren]ylene is in a wavelength range from 570 to 700 nm,
and where
the blue-emitting recurring unit **B** is selected from the structural elements of the 1,4-phenylene, 1,4-naphthylene, 1,4- or 9,10-anthracenylene, 1,6- or 2,7- or 4,9-pyrenylene, 2,7- or 3,6-phenanthrenylene, 4,4'-biphenylylene, 4,4"-terphenylylene, 4,4'-bi-1,1'-naphthylylene, 4,4'-stilbene derivatives, 4,4'-tolan derivatives, 4,5-dihydropyrene derivatives, 4,5,9,10-tetrahydropyrene derivatives, fluorene derivatives, spirobifluorene derivatives, 5,7-dihydrodibenzoxepine derivatives, 9,10-dihydrophenanthrene derivatives and bis-(styryl)arylenes, which may be substituted or unsubstituted;
and where
the red-emitting recurring units **R** are selected from the units of the formulae (XIII) to (XIX), which may be substituted or unsubstituted: 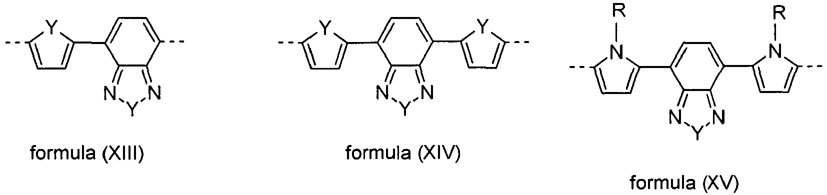 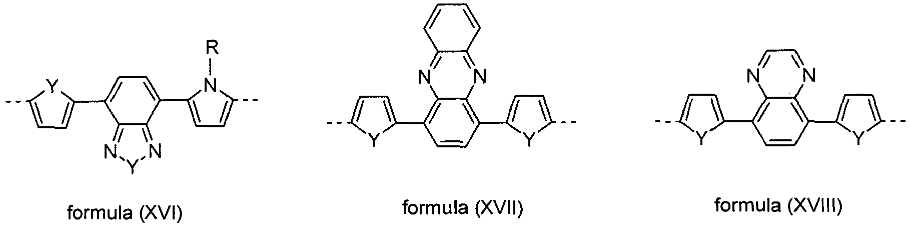 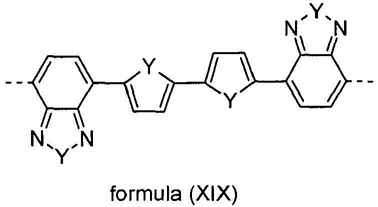 where the following applies to the symbols and indices used:
Y is on each occurrence, identically or differently, S or O;
R is on each occurrence, identically or differently, H, a straight-chain, branched or cyclic alkyl chain having 1 to 22 C atoms, in which, in addition, one or more non-adjacent C atoms may be replaced by O, S, -CO-O- or -O-CO-O-, where, in addition, one or more H atoms may be replaced by fluorine, or a substituted or unsubstituted aryl group having 5 to 40 C atoms, in which, in addition, one or more C atoms may be replaced by O, S or N;
the dashed bonds here indicate the linking in the polymer;
and where
the green-emitting recurring unit **G** is selected from the groups of the electron-rich bis(styryl)arylenes and corresponding extended structures, the quinoxalines, the phenothiazines, the dihydrophenazines, the bis(thienyl)arylenes, the oligo-(thienylenes), the phenazines and corresponding derivatives which contain oxygen instead of sulfur.

2. Copolymers according to Claim 1, **characterised in that** the green-emitting recurring units G are selected from the units of the formulae (I) to (III), (V), (VI), (VIII) and (XII), which may be substituted or unsubstituted: 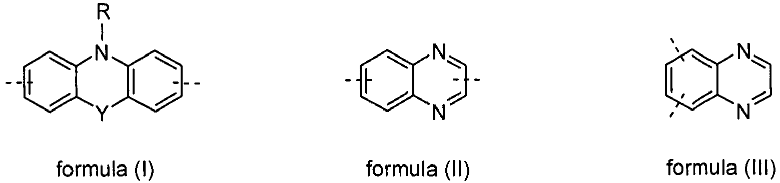 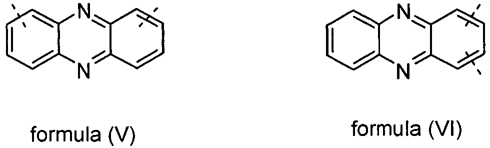 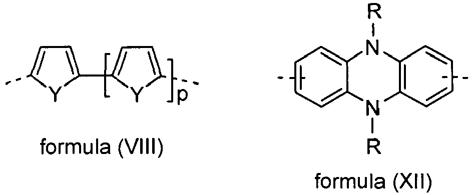 where the following applies to the symbols and indices used:
Y is on each occurrence, identically or differently, S or O;
R is on each occurrence, identically or differently, H, a straight-chain, branched or cyclic alkyl chain having 1 to 22 C atoms, in which, in addition, one or more non-adjacent C atoms may be replaced by O, S, -CO-O- or -O-CO-O-, where, in addition, one or more H atoms may be replaced by fluorine, or a substituted or unsubstituted aryl group having 5 to 40 C atoms, in which, in addition, one or more C atoms may be replaced by O, S or N;
p is on each occurrence, identically or differently, 1, 2, 3, 4 or 5;
the dashed bonds here indicate the linking in the polymer.

3. Copolymers according to one or more of Claims 1 or 2, **characterised in that** they contain additional recurring units which improve hole injection and/or hole transport and are selected from the groups of the triarylamine derivatives, triarylphosphine derivatives, benzidine derivatives, tetraarylene-para-phenylenediamine derivatives, thianthrene derivatives, dibenzo-p-dioxin derivatives, phenoxathiyne derivatives, carbazole derivatives, azulene derivatives, thiophene derivatives, pyrrole derivatives, furan derivatives and further O-, S- or N-containing heterocycles having a high HOMO.

4. Copolymers according to one or more of Claims 1 to 3, **characterised in that** the additional recurring units improve electron injection and/or electron transport and are selected from the groups of the pyridine derivatives, pyrimidine derivatives, pyridazine derivatives, pyrazine derivatives, triarylboranes, oxadiazole derivatives, quinoline derivatives, triazine derivatives and further O-, S- or N-containing heterocycles having a low LUMO.

5. Copolymers according to one or more of Claims 1 to 4, **characterised in that** the units support singlet-triplet transfer in the polymer and are selected from the groups of the carbazoles and the bridged carbazoles.

6. Blends comprising at least one copolymer according to one or more of Claims 1 to 5 and at least one further polymeric, oligomeric, dendritic or low-molecular-weight compound.

7. Solutions and formulations comprising one or more copolymers or blends according to one or more of Claims 1 to 6 in one or more solvents.

8. Use of a copolymer or blend according to one or more of Claims 1 to 6 as electroluminescent material in a polymeric light-emitting diode (PLED).

9. Polymeric light-emitting diode (PLED) having one or more active layers, where at least one of these active layers comprises a copolymer or blend according to one or more of Claims 1 to 6.

10. White-emitting display containing a PLED according to Claim 9.

11. Coloured, multicoloured or full-colour display, where the colour is generated through the use of a coloured filter on a white-emitting PLED according to Claim 9.

12. Lighting element containing a PLED according to Claim 9.

13. Liquid-crystal display (LCD) containing a white-emitting PLED according to Claim 9 and/or 10 as backlight.

14. Use of a copolymer or blend according to one or more of Claims 1 to 6 in an organic solar cell, organic laser diode, organic integrated circuit, organic field-effect transistor or organic thin-film transistor.

15. Organic solar cell, organic laser diode, organic integrated circuit, organic field-effect transistor or organic thin-film transistor containing at least one polymer or blend according to one or more of Claims 1 to 6.

## Revendications

1. Copolymères, conjugués ou partiellement conjugués, d'émission de blanc, contenant au moins trois unités récurrentes différentes, **caractérisés en ce que** la première unité récurrente, soit l'unité **B**, est présente selon une proportion d'au moins 50% mol. et présente une émission de bleu, la seconde unité récurrente, soit l'unité **G**, est présente selon une proportion de 0,01 à 0,5% mol. dans le polymère et présente une émission de vert et la troisième unité récurrente, soit l'unité **R**, est présente selon une proportion de 0,002 à 0,1% mol. et présente une émission de rouge, et le rapport des unités récurrentes d'émission de rouge sur les unités récurrentes d'émission de vert (unités **R : G**) est dans la plage de 1 : 20 à 1 : 2,
où une émission de bleu de l'unité récurrente **B** signifie qu'un film de l'homopolymère de cette unité **B** présente une luminescence et que le maximum de la courbe d'émission d'un film en un polymère qui comprend 10% mol. de cette unité **B** et 90% mol. de 2,7-[2',3',6',7'-tétra(2-méthylbutyloxy)spirobifluorène]ylène est dans une plage de longueurs d'onde de 400 à 490 nm,
où une émission de vert de l'unité récurrente **G** signifie que le maximum de la courbe de fluorescence ou de phosphorescence d'un film en un polymère qui comprend 10% mol. de cette unité **G** et 90% mol. de 2,7-[2',3',6',7'-tétra(2-méthylbutyloxy)spirobifluorène]-ylène est dans une plage de longueurs d'onde de 490 à 570 nm
et où une émission de rouge de l'unité récurrente **R** signifie que le maximum de la courbe de fluorescence ou de phosphorescence d'un film en un polymère qui comprend 10% mol. de cette unité **R** et 90% mol. de 2,7-[2',3',6',7'-tétra(2-méthylbutyloxy)spiro-bifluorène]ylène est dans une plage de longueurs d'onde de 570 à 700 nm,
et où
l'unité récurrente d'émission de bleu **B** est choisie parmi les éléments structurels constitués par des dérivés de 1,4-phénylène, 1,4-naphtylène, 1,4- ou 9,10-anthracénylène, 1,6- ou 2,7- ou 4,9-pyrénylène, 2,7- ou 3,6-phénanthrénylène, 4,4'-biphénylylène, 4,4"-terphénylylène, 4,4'-bi-1,1'-naphtylylène, 4,4'-stilbène, des dérivés de 4,4'-tolane, des dérivés de 4,5-dihydropyrène, des dérivés de 4,5,9,10-tétrahydropyrène, des dérivés de fluorène, des dérivés de spirobifluorène, des dérivés de 5,7-dihydrodibenzoxépine, des dérivés de 9,10-dihydrophénanthrène et des bis(styryl)arylènes, lesquels peuvent être substitués ou non substitués ;
et où
les unités récurrentes d'émission de rouge **R** sont choisies parmi les unités des formules (XIII) à (XIX), lesquelles peuvent être substituées ou non substituées : 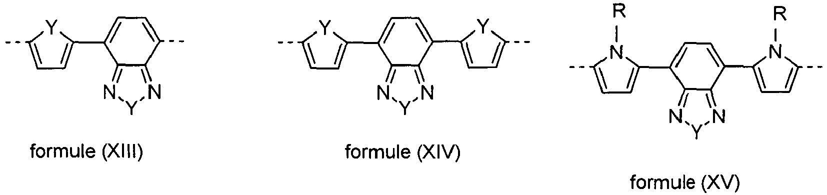 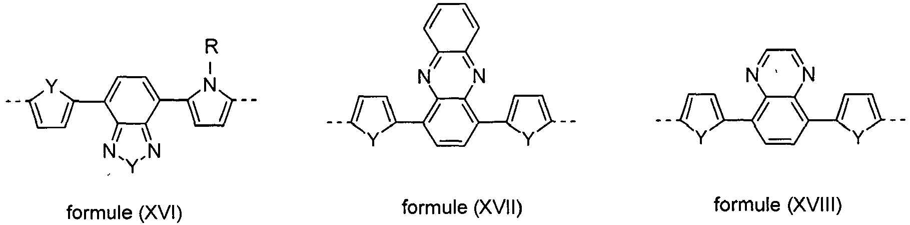 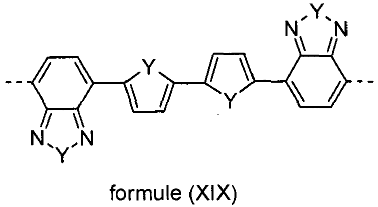 où ce qui suit s'applique aux symboles et indices utilisés :
Y est, pour chaque occurrence, de manière identique ou différente, S ou O ;
R est, pour chaque occurrence, de manière identique ou différente, H, une chaîne alkyle en chaîne droite, ramifiée ou cyclique comportant de 1 à 22 atomes de C, où, en plus, un ou plusieurs atomes de C non adjacents peut/peuvent être remplacé(s) par O, S, -CO-O- ou -O-CO-O-, où, en plus, un ou plusieurs atomes de H peut/peuvent être remplacé(s) par fluor, ou un groupe aryle substitué ou non substitué comportant de 5 à 40 atomes de C, où, en plus, un ou plusieurs atomes de C peut/peuvent être remplacé(s) par O, S ou N ; les liens en pointillés indiquent ici la liaison dans le polymère ;
et où
l'unité récurrente d'émission de vert **G** est choisie parmi les groupes des bis-(styryl)arylènes riches en électrons et des structures étendues correspondantes, les quinoxalines, les phénothiazines, les dihydrophénazines, les bis(thiényl)-arylènes, les oligo(thiénylènes), les phénazines et les dérivés correspondants qui contiennent de l'oxygène en lieu et place du soufre.

2. Copolymères selon la revendication 1, **caractérisés en ce que** les unités récurrentes d'émission de vert **G** sont choisies parmi les unités des formules (I) à (III), (V), (VI), (VIII) et (XII), lesquelles peuvent être substituées ou non substituées : 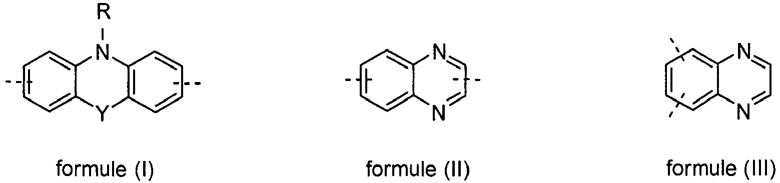 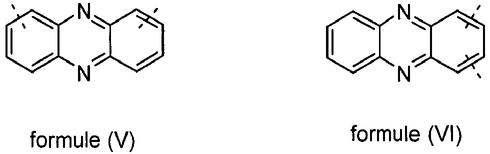 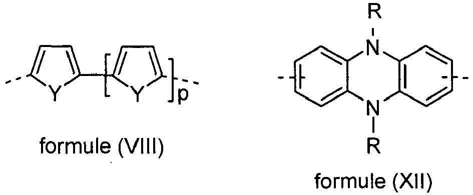 où ce qui suit s'applique aux symboles et indices utilisés :
Y est, pour chaque occurrence, de manière identique ou différente, S ou O ;
R est, pour chaque occurrence, de manière identique ou différente, H, une chaîne alkyle en chaîne droite, ramifiée ou cyclique comportant de 1 à 22 atomes de C, où, en plus, un ou plusieurs atomes de C non adjacents peut/peuvent être remplacé(s) par O, S, -CO-O- ou -O-CO-O-, où, en plus, un ou plusieurs atomes de H peut/peuvent être remplacé(s) par fluor, ou un groupe aryle substitué ou non substitué comportant de 5 à 40 atomes de C, où, en plus, un ou plusieurs atomes de C peut/peuvent être remplacé(s) par O, S ou N ;
p est, pour chaque occurrence, de manière identique ou différente, 1, 2, 3, 4 ou 5 ;
les liens en pointillés indiquent ici la liaison dans le polymère.

3. Copolymères selon une ou plusieurs des revendications 1 ou 2, **caractérisés en ce qu'**ils contentent des unités récurrentes additionnelles qui améliorent l'injection de trous et/ou le transport de trous et qui sont choisies parmi les groupes constitués par les dérivés de triarylamine, les dérivés de triarylphosphine, les dérivés de benzidine, les dérivés de tétraarylène-para-phénylènediamine, les dérivés de thianthrène, les dérivés de dibenzo-p-dioxine, les dérivés de phénoxathiyne, les dérivés de carbazole, les dérivés d'azulène, les dérivés de thiophène, les dérivés de pyrrole, les dérivés de furane et d'autres hétérocycles contenant O, S ou N présentant un HOMO élevé.

4. Copolymères selon une ou plusieurs des revendications 1 à 3, **caractérisés en ce que** les unités récurrentes additionnelles améliorent l'injection d'électrons et/ou le transport d'électrons et sont choisies parmi les groupes constitués par les dérivés de pyridine, les dérivés de pyrimidine, les dérivés de pyridazine, les dérivés de pyrazine, les triarylboranes, les dérivés d'oxadiazole, les dérivés de quinoline, les dérivés de triazine et d'autres hétérocycles contenant O, S ou N présentant un LUMO faible.

5. Copolymères selon une ou plusieurs des revendications 1 à 4, **caractérisés en ce que** les unités supportent un transfert singlet-triplet dans le polymère et sont choisies parmi les groupes constitués par les carbazoles et les carbazoles pontés.

6. Mélanges comprenant au moins un copolymère selon une ou plusieurs des revendications 1 à 5 et au moins un autre composé polymérique, oligomérique, dendritique ou de poids moléculaire faible.

7. Solutions et formulations comprenant un ou plusieurs copolymères ou mélanges selon une ou plusieurs des revendications 1 à 6 dans un ou plusieurs solvants.

8. Utilisation d'un copolymère ou mélange selon une ou plusieurs des revendications 1 à 6 dans une diode émettrice de lumière polymérique (PLED) en tant que matériau électroluminescent.

9. Diode émettrice de lumière polymérique (PLED) comportant une ou plusieurs couches actives, où au moins l'une des ces couches actives comprend un copolymère ou mélange selon une ou plusieurs des revendications 1 à 6.

10. Affichage d'émission de blanc contenant une PLED selon la revendication 9.

11. Affichage couleur, multicouleur ou pleine couleur, où la couleur est générée par l'intermédiaire de l'utilisation d'un filtre couleur sur une PLED d'émission de blanc selon la revendication 9.

12. Élément d'éclairage contenant une PLED selon la revendication 9.

13. Affichage à cristaux liquides (LCD) contenant une PLED d'émission de blanc selon la revendication 9 et/ou 10 en tant qu'éclairage arrière.

14. Utilisation d'un copolymère ou mélange selon une ou plusieurs des revendications 1 à 6 dans une cellule solaire organique, une diode laser organique, un circuit intégré organique, un transistor à effet de champ organique ou un transistor à film mince organique.

15. Cellule solaire organique, diode laser organique, circuit intégré organique, transistor à effet de champ organique ou transistor à film mince organique contenant au moins un polymère ou mélange selon une ou plusieurs des revendications 1 à 6.
